(19) Europäisches Patentamt / European Patent Office / Office européen des brevets

(11) **EP 4 592 431 A1**

(12) **EUROPEAN PATENT APPLICATION**
published in accordance with Art. 153(4) EPC

(43) Date of publication:
**30.07.2025 Bulletin 2025/31**

(21) Application number: **23868114.2**

(22) Date of filing: **13.09.2023**

(51) International Patent Classification (IPC):
**C30B 29/42** (2006.01)      **C30B 11/00** (2006.01)
**C30B 27/00** (2006.01)

(52) Cooperative Patent Classification (CPC):
**C30B 11/00; C30B 27/00; C30B 29/42**

(86) International application number:
**PCT/JP2023/033402**

(87) International publication number:
**WO 2024/062991 (28.03.2024 Gazette 2024/13)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **21.09.2022   JP 2022150753
12.09.2023   JP 2023147887**

(71) Applicant: **DOWA Electronics Materials Co., Ltd.
Tokyo 101-0021 (JP)**

(72) Inventor: **SUNACHI Naoya
Tokyo 101-0021 (JP)**

(74) Representative: **Müller-Boré & Partner
Patentanwälte PartG mbB
Friedenheimer Brücke 21
80639 München (DE)**

(54) **METHOD FOR PRODUCING GAAS INGOT, AND GAAS INGOT**

(57)      Provided are a method of producing a GaAs ingot and a GaAs ingot that efficiently yield a GaAs wafer having a strictly controlled carrier concentration and a low dislocation density. The method of producing a GaAs ingot includes performing crystal growth by a vertical boat method with a seed crystal, a Si feedstock serving as a dopant, a GaAs feedstock, and boron oxide serving as an encapsulant accommodated in a crucible. The GaAs feedstock is Si-doped GaAs having a Si concentration of 20 wt ppm to 200 wt ppm relative to GaAs. A charged amount of the Si feedstock is 200 wt ppm to 300 wt ppm relative to GaAs. The boron oxide contains $SiO_2$ in a Si-equivalent amount of more than 5 mol%. The crystal growth is performed under stirring of liquid boron oxide after melting the Si feedstock, the GaAs feedstock, and the boron oxide through heating.

*FIG. 3*

EP 4 592 431 A1

**Description**

TECHNICAL FIELD

The present disclosure relates to a method of producing a GaAs ingot and a GaAs ingot.

BACKGROUND

Known methods of producing a GaAs single crystal (hereinafter, also referred to as a GaAs ingot) in order to obtain a GaAs single crystal wafer (hereinafter, also referred to as a GaAs wafer) include the liquid encapsulated Czochralski (LEC) method, the horizontal boat (HB) method, the vertical gradient freeze (VGF) method, and the vertical Bridgman (VB) method. The ingot is a lump having a single crystal straight body section obtained through crystal growth by any of the methods mentioned above with a seed crystal that is a single crystal as a starting point, and the wafer is cut out from the straight body section of this ingot. A plurality of GaAs wafers are obtained from the same GaAs ingot, and these wafers are also referred to as a wafer group.

In a vertical boat method such as the vertical gradient freeze (VGF) method or the vertical Bridgman (VB) method, a seed crystal is placed at the bottom of a crucible, a single crystal feedstock melt and a liquid encapsulant are provided on an upper layer of the seed crystal, and the crucible is cooled from a specific temperature profile to cause crystal growth upward from the bottom of the feedstock melt. In the vertical gradient freeze (VGF) method, it is the temperature itself that is lowered, whereas in the vertical Bridgman (VB) method, the crucible is relatively moved in a specific temperature profile. When a Si-doped GaAs single crystal ingot is to be produced, Si is added into a GaAs melt. Boron oxide ($B_2O_3$) is normally used as an encapsulant in order to prevent As, which is a volatile component, dissociating from the ingot. A redox reaction according to the following reaction formula (1) is known to occur at the interface between the GaAs melt and the liquid $B_2O_3$ during crystal growth.

$$3Si \text{ (in melt)} + 2B_2O_3 = 3SiO_2 \text{ (in } B_2O_3) + 4B \text{ (in melt) ...} \qquad (1)$$

Since a vertical boat method causes a crystal to grow in an upward direction from the bottom of the feedstock melt, impurities that are not incorporated into the crystal are concentrated in the melt. In a situation in which the amount of Si as a dopant that is added into the GaAs melt (i.e., Si crystals loaded together with a GaAs feedstock) is increased in order to increase the carrier concentration, the equilibrium of reaction formula (1) is shifted to the right, and a large amount of boron (B) migrates into the GaAs melt. This causes the formation of boron arsenide as crystal growth progresses and impurity concentration progresses, and means that high crystallinity cannot be achieved. In other words, there is a trade-off relationship between carrier concentration and crystallinity in a GaAs single crystal obtained by this production method.

Patent Literature (PTL) 1 proposes a method of producing a GaAs single crystal having a high carrier concentration and a high crystallinity by arranging solid silicon dioxide having a plate-like form at an interface between a GaAs melt and liquid $B_2O_3$ in a vertical boat method.

CITATION LIST

Patent Literature

PTL 1: JP2012-246156A

SUMMARY

(Technical Problem)

Even among semiconductor lasers, the adoption of surface-emitting lasers such as VCSELs (vertical-cavity surface-emitting lasers) has been actively promoted in recent years for applications such as optical communications and optical sensing. Silicon (Si) doped n-type GaAs wafers are used as element substrates in these applications, and such GaAs wafers are required to have a strictly controlled carrier concentration and a low dislocation density. Specifically, it is desirable for the carrier concentration to be within a range of not less than $1.5 \times 10^{18}$ cm$^{-3}$ and not more than $2.9 \times 10^{18}$ cm$^{-3}$ and, with regards to low dislocation density, it is desirable for a maximum value for etch pit density to be 1,200 cm$^{-2}$ or less in the case of a wafer of smaller than 6 inches (for example, 4 inches or smaller) and for a maximum value for etch pit density to be 1,500 cm$^{-2}$ or less in the case of a wafer of 6 inches or larger.

Only a limited number of wafers satisfying these conditions relating to carrier concentration and maximum value for etch pit density can be obtained from the GaAs ingot disclosed in PTL 1, and thus productivity remains an issue.

(Solution to Problem)

During crystal growth, segregation of Si normally causes the Si concentration in a GaAs melt to increase as crystallization progresses, thus resulting in an increase of Si concentration, and also of carrier concentration in accompaniment thereto, from a seed side toward a tail side of an ingot. In a situation in which the amount of a Si feedstock serving as a dopant that is added to a GaAs melt is increased in order to ensure that the carrier concentration at a seed side of a straight body section of an ingot, which constitutes a lower limit of carrier concentration, is at least $1.5 \times 10^{18}$ cm$^{-3}$, polycrystal formation may occur during initial crystal growth and it may not be possible to obtain a single crystal ingot. For example, polycrystal formation readily occurs when production of a GaAs ingot for 4 inch wafers is performed using a GaAs feedstock that does not contain Si and using a Si feedstock as a dopant in an amount exceeding 300 wt ppm. As a result of extensive and diligent research to achieve the object set forth above, the inventor discovered that in a method of producing a GaAs ingot by performing crystal growth by a vertical boat method with a seed crystal, a Si feedstock serving as a dopant, a GaAs feedstock, and boron oxide serving as an encapsulant accommodated in a crucible, by doping the GaAs feedstock serving as a feedstock with a specific amount of Si in addition to using the Si feedstock as a dopant and by providing a specific amount of $SiO_2$ in the boron oxide serving as an encapsulant, it is possible to control the Si concentration in the GaAs melt during crystal growth such that a carrier concentration and an etch pit density that are within desired ranges can be achieved in the majority of a straight body section of the ingot without causing polycrystal formation in the ingot even in a situation in which the total amount of Si in the melt is an amount (for example, 300 wt ppm for 4 inch wafers) that may result in polycrystal formation in a case in which the GaAs feedstock is not doped with the specific amount of Si. In this manner, the inventor completed the present disclosure. In the following description, an amount determined by adding together the amount of Si in a Si feedstock serving as a dopant and the amount of Si in a GaAs feedstock is referred to as the total charged amount of Si.

Primary configurations of the present disclosure are as follows.

[1] A method of producing a GaAs ingot comprising performing crystal growth by a vertical boat method with a seed crystal, a Si feedstock serving as a dopant, a GaAs feedstock, and boron oxide serving as an encapsulant accommodated in a crucible, wherein

the GaAs feedstock is Si-doped GaAs having a Si concentration of 20 wt ppm to 200 wt ppm relative to GaAs, a charged amount of the Si feedstock is 200 wt ppm to 300 wt ppm relative to GaAs, the boron oxide contains $SiO_2$ in a Si-equivalent amount of more than 5 mol%, and the crystal growth is performed under stirring of liquid boron oxide after melting the Si feedstock, the GaAs feedstock, and the boron oxide through heating.

[2] The method of producing a GaAs ingot according to [1], wherein the method is:

a method of producing a GaAs ingot including a straight body section having a diameter of 140 mm or less, wherein a total charged amount of Si determined by totaling Si in the GaAs feedstock and the Si feedstock is more than 300 wt ppm relative to GaAs; or a method of producing a GaAs ingot including a straight body section having a diameter of more than 140 mm, wherein the charged amount of the Si feedstock is 200 wt ppm to 250 wt ppm relative to GaAs, and a total charged amount of Si determined by totaling Si in the GaAs feedstock and the Si feedstock is more than 250 wt ppm relative to GaAs.

[3] A GaAs ingot that:

comprises a straight body section having a diameter of 140 mm or less and yields a wafer having a carrier concentration of $1.5 \times 10^{18}$ cm$^{-3}$ to $2.9 \times 10^{18}$ cm$^{-3}$ and a maximum value for etch pit density of 1,200 cm$^{-2}$ or less from 70% or more of the straight body section; or comprises a straight body section having a diameter of more than 140 mm and yields a wafer having a carrier concentration of $1.5 \times 10^{18}$ cm$^{-3}$ to $2.9 \times 10^{18}$ cm$^{-3}$ and a maximum value for etch pit density of 1,500 cm$^{-2}$ or less from 70% or more of the straight body section.

(Advantageous Effect)

According to the present disclosure, a GaAs ingot that efficiently yields a GaAs wafer having a strictly controlled carrier concentration and a low dislocation density and a method of producing this GaAs ingot are provided.

BRIEF DESCRIPTION OF THE DRAWINGS

In the accompanying drawings:

FIG. 1 is a schematic view of a GaAs ingot according to the present disclosure;
FIG. 2 is a schematic view in which 69 areas are set in a 6 inch wafer in order to measure etch pit density (EPD);
FIG. 3 is a cross-sectional schematic view of a production apparatus used in production of a GaAs ingot according to the present disclosure; and
FIG. 4 is a cross-sectional view of a crucible 3 used in production of a GaAs ingot according to the present disclosure and corresponds to a state in which feedstocks, etc. have been loaded prior to the start of crystal growth.

DETAILED DESCRIPTION

The following describes embodiments of the present disclosure with reference to the drawings.

<GaAs ingot>

(Seed side, central portion, and tail side of GaAs ingot)

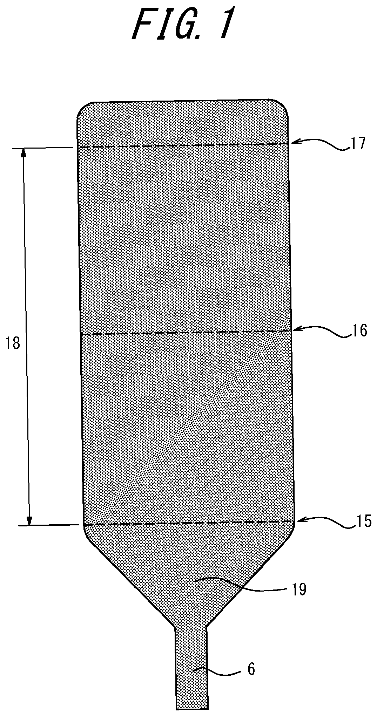

FIG. 1 is a schematic view of a GaAs ingot according to the present disclosure that indicates a position 15 where a cone section changes to a straight body section, a position (midpoint) 16 at half the length from the position 15 to a position 17, and a position 17 where the straight body section ends. The GaAs ingot has a straight body section 18 of roughly constant diameter that is reached through a region 19 (also referred to as a cone section) where the diameter of the GaAs ingot increases from a seed crystal 6 (also referred to as a seed). A section up to where growth is complete from the position 17 at which the straight body section ends is referred to as a tail. When the length from the position 15 where the cone section changes to the straight body section up to the position 17 where the straight body section (section subjected to wafer processing) ends is taken to be 100% and when the former position 15 is set as 0% and the latter position 17 is set as 100%, a range from 0% to 5% is referred to as a seed side of the straight body section (hereinafter, also referred to simply as the seed side), a range from 40% to 60% is referred to as a central portion of the straight body section (hereinafter, also referred to simply as the central portion), and a range from 88% to 100% is referred to as a tail side of the straight body section (hereinafter, also referred to simply as the tail side). The position 17 at which the straight body section ends (100% position) is set as a position corresponding to a volume of 90% relative to 100% of volume of the entire ingot (i.e., a position corresponding to a crystallization ratio of 90%).

FIG. 1 also indicates a position 16 that is a midpoint (50%) between the position 15 and the position 17. In the following description, the position 16 is also referred to simply as the midpoint.

The position of each wafer in the straight body section as indicated as a percentage position from the end of the seed side of the straight body section is also referred to as the "position from the straight body seed". A solid-liquid interface moves from the seed side 15 toward the tail side 17 in crystal growth of the GaAs ingot.

The carrier concentration and average and maximum values for etch pit density (EPD) relating to the GaAs ingot according to the present disclosure can be determined through measurement of wafers that are obtained from the straight body section 18 of the GaAs ingot.

The GaAs ingot 18 may have a diameter of less than 140 mm or may have a diameter of 140 mm or more without any specific limitations. For example, the diameter of the GaAs ingot 18 can be set as not less than 50 mm and less than 140 mm or can be set as not less than 140 mm and not more than 162 mm.

The wafer size can be selected as appropriate depending on the diameter of the straight body section 18 of the GaAs ingot. For example, the wafer size can be set as 2 inches to 8 inches. The wafer size is normally less than 6 inches in a case in which the diameter of the GaAs ingot 18 is less than 140 mm, whereas the wafer size is normally 6 inches or more in a case in which the diameter of the GaAs ingot 18 is 140 mm or more.

<Method of producing GaAs ingot>

A method of producing a GaAs ingot according to the present disclosure includes performing crystal growth by a vertical boat method with a seed crystal, a Si feedstock serving as a dopant, a GaAs feedstock, and boron oxide serving as an encapsulant accommodated in a crucible. The vertical boat method can be the vertical gradient freeze (VGF) method or the vertical Bridgman (VB) method.

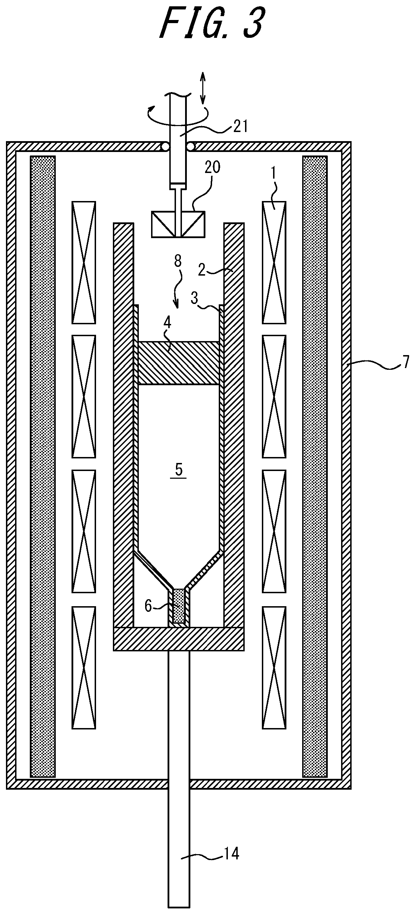

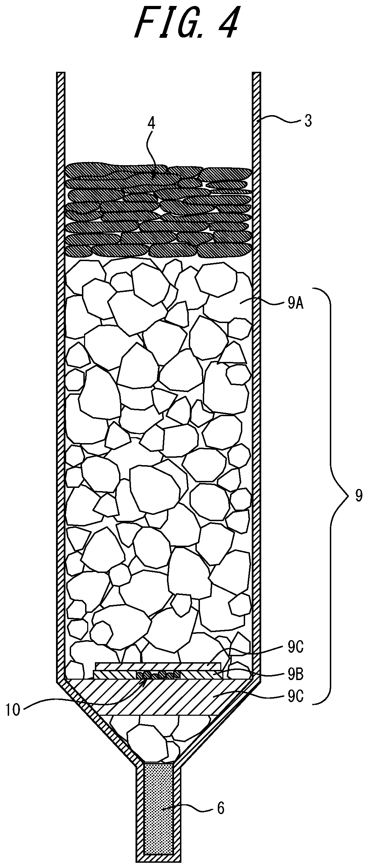

The following provides a more detailed description of this production method with reference to FIG. 3 and FIG. 4.

(Production apparatus and temperature control)

FIG. 3 schematically illustrates a cross-sectional view for one example of a production apparatus for use in the method of producing a GaAs ingot according to the present disclosure.

The production apparatus illustrated in FIG. 3 includes an airtight container 7 that can be vacuum evacuated and filled with an atmosphere gas from the outside, a crucible 3 that is arranged centrally inside of the airtight container 7, a crucible receiving container (susceptor) 2 that accommodates and holds the crucible 3, a mechanism 14 (only a raising/lowering and rotating rod is illustrated) for raising/lowering and/or rotating the crucible receiving container (susceptor) 2, and a heater 1 that is installed such as to surround the crucible receiving container (susceptor) 2 inside the airtight container 7.

An upper rod 21 having a stirring blade 20 that can be rotated and moved up and down attached thereto is arranged at the top the crucible 3. The stirring blade 20 and the upper rod 21 constitute a stirring means, but the stirring blade 20 can be removed from the upper rod 21, and an encapsulant receiving container or another member can be attached to the upper rod 21.

The crucible 3 can be a crucible that is formed of pyrolytic boron nitride (PBN). FIG. 3 illustrates a state in which a seed crystal 6, a compound semiconductor feedstock 5 (also referred to as a feedstock melt), and boron oxide ($B_2O_3$) 4 serving as an encapsulant have been loaded into the crucible 3 and in which an inert gas 8, as one example, has been loaded into the airtight container 7.

FIG. 4 schematically illustrates a cross-sectional view for one example of a crucible for use in the method of producing a GaAs ingot according to the present disclosure and corresponds to a state in which feedstocks, etc. have been loaded prior to the start of crystal growth. The crucible 3 illustrated in FIG. 4 has been loaded with a seed crystal 6, a GaAs feedstock 9, a Si feedstock 10 serving as a dopant, and boron oxide 4 serving as an encapsulant. In FIG. 4, crushed polycrystalline GaAs (9A), circular tube-shaped polycrystalline GaAs (9B), and disk-shaped polycrystalline GaAs (9C) are prepared as the GaAs feedstock 9, and the Si feedstock is arranged in a container created through the circular tube-shaped polycrystalline GaAs (9B) and the disk-shaped polycrystalline GaAs (9C). However, this configuration is not a limitation and it may alternatively be the case that only crushed polycrystalline GaAs is loaded, for example.

Once loading of these materials is complete, the GaAs feedstock 9 is heated to at least the melting point of GaAs (1238°C) so as to melt the GaAs feedstock 9 and the boron oxide 4 and cause dissolution of the Si feedstock 10 in the GaAs feedstock 9 while also applying a temperature gradient through a PID controlled heater inside of the growth furnace where the inert gas has been loaded such that the temperature at the side where the seed crystal 6 is located is lower in order that the seed crystal 6 does not melt. Next, the temperature in proximity to the seed crystal 6 is raised, and, once the top of the seed crystal 6 has melted, the overall temperature is gradually lowered while applying a temperature gradient. In this manner, a GaAs ingot can be obtained. The cooling rate at this time is preferably 10°C/h or less.

(Stirring)

In the method of producing GaAs according to the present disclosure, liquid boron oxide 4 is stirred during crystal growth. Stirring is preferably initiated in a period between a point at which crystal growth starts at the seed side of the straight body section and the midpoint (i.e., while the position from the straight body seed is 1% to 50%). The stirring is preferably continued until crystal growth of the tail side of the straight body section ends, and may be continued until crystal growth is complete.

The stirring is preferably performed by positioning a stirring means in the encapsulant (boron oxide 4) and rotating the stirring means. In the present disclosure, it is desirable to maintain a comparatively high Si concentration in the feedstock melt with as little absorption of Si by the encapsulant as possible from the start of crystal growth to the start of stirring, and stirring is used to the minimum level necessary with the aim of inhibiting a dramatic rise of Si concentration due to segregation. Accordingly, the rotation speed may be changed in stages or continuously from the seed side toward the tail side of the straight body section, but the maximum rotation speed that is reached is preferably 3 rpm or less.

The stirring means can have a form in which the stirring blade 20 is attached around a rotation axle.

Although no specific limitations are placed on the shape of the stirring blade 20, the stirring blade 20 can be formed of plate-like members of a specific shape. For example, the stirring blade 20 may be formed of 2 to 8 plate-like members each having a roughly quadrangular shape and may have carbon, BN, or the like as a material. The plate-like members are preferably attached at an inclined angle of not less than 45° and not more than 135° relative to an interface formed by the feedstock melt and the boron oxide 4 when in a stationary state.

The area formed by a rotation trajectory of the stirring blade 20 during rotation of the stirring means is preferably of a size equivalent to 30% or more, and more preferably 70% or more of the area of the interface formed by the feedstock melt and the boron oxide 4 when in a stationary state.

The distance between a lower end of the stirring blade 20 and the interface formed by the feedstock melt and the boron oxide 4 when in a stationary state is preferably less than 2 mm, and is preferably 1 mm or less. However, it is preferably that the lower end of the stirring blade 20 is not in contact with the interface.

The stirring is preferably performed with a rotation speed of 0.5 rpm or more, and more preferably with a rotation speed of 2.5 rpm or more at a timing at which crystal growth has progressed to the midpoint. This is because beyond the midpoint, segregation of Si in the melt increases and the carrier concentration tends to exceed $2.5 \times 10^{18}$ cm$^{-3}$. Therefore, intensifying stirring at around this time promotes absorption into the encapsulant of Si that is present in the melt, inhibits a sudden rise of Si concentration due to segregation, and also inhibits formation of dislocations and a sudden rise of carrier concentration.

(Seed crystal)

A commonly known seed crystal can be used as the seed crystal 6 without any specific limitations. Although no specific limitations are placed on the size of the seed crystal 6, the seed crystal 6 may have a cross-sectional area of 1% to 20% relative to a cross-sectional area having a diameter corresponding to the internal diameter of the crucible 3, for example, and preferably has a cross-sectional area of 3% to 17% relative thereto. In a case in which a crystal having a diameter of more than 100 mm is to be grown, the cross-sectional area of the seed crystal 6 can be set as 2% to 10% relative to a cross-sectional area having a diameter corresponding to the internal diameter of the crucible.

(Crucible internal diameter and wafer size)

The internal diameter of the crucible 3 is preferably slightly larger than the target wafer size. The target wafer size can be 2 inches or more, for example, and is preferably 3 inches or more. Although no specific limitations are placed on the upper limit for the wafer size, the upper limit can be set as 8 inches or less, for example. Wafers having diameters of 2 inches to 4 inches, for example, are produced from ingots having a straight body section diameter of 140 mm or less, whereas wafers having diameters of 6 inches to 8 inches, for example, are produced from ingots having a straight body section diameter of more than 140 mm.

(GaAs feedstock)

Si-doped GaAs having a Si concentration of 20 wt ppm to 200 wt ppm relative to GaAs is used as the GaAs feedstock. The GaAs feedstock that is used may be polycrystalline or single crystal. The Si concentration in the GaAs feedstock refers to the Si concentration as calculated from the carrier concentration measured through Hall measurement. When the Si concentration calculated from the carrier concentration is within this range, single crystal formation is not impaired in crystal growth even when the total charged amount of Si relative to GaAs, determined through totaling with the subsequently described Si feedstock 10, is large, and the carrier concentration in the obtained GaAs ingot can easily be controlled to within a desired range. Since the GaAs feedstock is melted and then used, the Si concentration as an average for the overall GaAs feedstock that is used should be within the range set forth above, and GaAs feedstocks having different Si concentrations may be used in combination.

The Si concentration in Si-doped polycrystalline GaAs as calculated from the carrier concentration can be measured and calculated as follows. Note that the Si concentration can be calculated by a similar method in the case of a single crystal. The method of converting carrier concentration to Si concentration described below is a method for a case in which the dopant of GaAs is Si and in which other p-type dopants and n-type dopants are not intentionally included in the GaAs.

<Carrier concentration according to Hall measurement>

- Cut out a wafer-shaped material of approximately 1 mm in thickness from a seed side and a tail side of Si-doped polycrystalline GaAs.
- Use a scriber to make a scratch with a size of 10 mm-square from as large as possible a crystal grain boundary in the wafer-shaped material (polycrystal) and cut out a sample with a size of 10 mm-square from a central portion of the wafer-shaped material.
- Attach indium electrodes at four corners of the sample, perform heating to 330°C to 360°C, and then measure the carrier concentration by the Van der Pauw method.

<Conversion to Si concentration using activation rate>

- Take the activation rate to be 48% and divide the value for carrier concentration by 0.48 to calculate a value (cm$^{-3}$) for Si atom concentration.
- Use the bulk density of GaAs (5.3161 g/cm$^3$), Avogadro's number, and the atomic mass of Si (28.1) to convert the value for Si atom concentration from units of cm$^{-3}$ to units of wt ppm.

[Math. 1]

$$\text{Si concentration (wt ppm)} = \left[ \frac{\text{Si atom concentration (cm}^{-3}) \times \text{Si atomic mass}}{\text{Bulk density (g/cm}^3) \times \text{Avogadro's number}} \right] \times 10^6$$

The method by which the Si-doped GaAs serving as the GaAs feedstock is synthesized may be a method in which the Si-doped GaAs is synthesized by a vertical boat method in a crucible, a method in which the Si-doped GaAs is synthesized by a horizontal boat method in a boat set up inside of an ampoule, or the like without any limitations, and a Si feedstock is charged in an amount corresponding to the desired Si concentration relative to GaAs in this synthesis.

In a case in which a vertical boat method is adopted, Si-doped polycrystalline GaAs can be obtained by performing crystal growth with high-purity Ga, high-purity As, and a Si feedstock (for example, high-purity Si shot or crushed high-purity Si substrate) loaded into a crucible, for example. Loading into the crucible can be performed by loading half of the high-purity As, all of the Si feedstock, the remaining half of the high-purity As, and then the high-purity Ga in this order, though the loading order is not limited to this order. In synthesis of polycrystalline GaAs, it is preferable that boron oxide is not used as an encapsulant from a viewpoint of promoting Si doping and a viewpoint of limiting the amount of boron in the GaAs melt when the polycrystalline GaAs is used as the GaAs feedstock.

A recycled product obtained through processing and/or crushing of a section of another Si-doped GaAs single crystal ingot that is not a straight body section and that is not subjected to wafer processing (for example, a cone section or a region beyond the tail side of the straight body section) or of a superfluous section arising during wafer processing can be used in the Si-doped GaAs serving as the GaAs feedstock.

(Dopant)

The Si feedstock 10 is used as a dopant. The Si feedstock 10 can be high-purity Si shot or crushed high-purity Si substrate and is added into the GaAs feedstock 9.

The charged amount of the Si feedstock 10 is set as an amount of 200 wt ppm to 300 wt ppm relative to GaAs of the GaAs feedstock 9. The charged amount is more preferably set as 220 wt ppm to 300 wt ppm, and even more preferably set as 240 wt ppm to 290 wt ppm.

In the case of an ingot including a straight body section having a diameter of 140 mm or less, the total charged amount of Si determined by totaling Si in the GaAs feedstock and the Si feedstock 10 is preferably more than 300 wt ppm relative to GaAs. In this case, the charged amount of the Si feedstock 10 is more preferably set as 220 wt ppm to 300 wt ppm relative to GaAs.

In the case of an ingot including a straight body section having a diameter of more than 140 mm, the charged amount of the Si feedstock 10 is preferably set as 200 wt ppm to 250 wt ppm, and more preferably set as 220 wt ppm to 250 wt ppm relative to GaAs, and the total charged amount of Si determined by totaling Si in the GaAs feedstock and the Si feedstock 10 is preferably more than 250 wt ppm relative to GaAs.

In production of a GaAs ingot for 4 inch wafers, for example, polycrystal formation tends to occur when a GaAs feedstock that does not contain Si is used and more than 300 wt ppm of a Si feedstock is added as a dopant, and in production of a GaAs ingot for 6 inch wafers, for example, polycrystal formation tends to occur when a GaAs feedstock that does not contain Si is used and more than 250 wt ppm of a Si feedstock is added as a dopant. However, in a situation in which Si is included in the GaAs feedstock in advance as in the present disclosure, it is possible to provide Si in the GaAs melt and to increase the carrier concentration of the entire straight body section without polycrystal formation even when the total charged amount of Si is set as an amount such as described above.

By controlling the total charged amount of Si in this manner, it is easy to control the carrier concentration in the obtained GaAs ingot to within a desired range without impairing single crystal formation during crystal growth.

The charged amount of the Si feedstock 10 does not include the amount of silicon that is contained in the Si-doped GaAs feedstock and the boron oxide. The total charged amount of Si does not include the amount of silicon that is contained in the boron oxide.

The Si feedstock 10 is preferably arranged lower than (at the seed crystal side of) the center of the crucible (position corresponding to a central portion of the ingot). The Si feedstock 10 may be placed in a GaAs container such that the dopant in the container does not migrate out of the container until the temperature at which the GaAs container melts is reached. As a consequence of silicon having a lower density than GaAs, the dopant (silicon) may float up in the melt, resulting in lower silicon concentration at the seed crystal side in the GaAs melt and lower silicon concentration at the seed side of the GaAs ingot. This can be effectively avoided through use of a GaAs container. A container obtained through processing of the GaAs feedstock can be used as the GaAs container, and this container may be obtained through processing of a Si-doped GaAs single crystal or through processing of Si-doped polycrystalline GaAs.

An amphoteric dopant can be used in addition to the Si feedstock 10 to the extent that the effects according to the present disclosure are not lost. For example, an In feedstock such as high-purity In or an indium compound (for example, high-purity indium arsenide (InAs)) may be used.

Other elements that may be considered as dopants include beryllium (Be), magnesium (Mg), aluminum (Al), carbon (C), germanium (Ge), tin (Sn), nitrogen (N), sulfur (S), selenium (Se), tellurium (Te), zinc (Zn), cadmium (Cd), chromium (Cr), and antimony (Sb). Although inclusion of these elements in an unavoidable amount is tolerable, it is preferable that these elements are not intentionally added.

(Encapsulant)

Boron oxide ($B_2O_3$) 4 is used as an encapsulant. The boron oxide 4 contains $SiO_2$ in a Si-equivalent amount of more than 5 mol%. When the amount is within this range, the amount of Si in the feedstock melt that is absorbed by the $B_2O_3$ can be suppressed, incorporation of B of the $B_2O_3$ into the single crystal can be prevented, and the Si concentration of the feedstock melt can be controlled to within a suitable range when stirring is performed. The amount of $SiO_2$ that is contained in the boron oxide 4 is preferably a Si-equivalent amount of 6 mol% or more. Since there is a limit to the amount of solid dissolution of Si in boron oxide, the amount of $SiO_2$ that is contained in the boron oxide 4 can be set as a Si-equivalent amount of 10 mol% or less, and is preferably a Si-equivalent amount of 7 mol% or less.

The boron oxide 4 serving as an encapsulant can be set as 0.02 wt% or more, and is preferably 0.03 wt% or more relative to the GaAs feedstock 9 from a viewpoint of inhibiting As escape from the feedstock melt. Moreover, the boron oxide 4 serving as the encapsulant can be set as 0.10 wt% or less, and is preferably 0.06 wt% or less relative to the GaAs feedstock 9 from a viewpoint of avoiding excessive intake of Si by the stirred encapsulant.

Through the method of producing a GaAs ingot according to the present disclosure, it is possible to obtain a GaAs ingot that includes a straight body section having a diameter of 140 mm or less and yields a wafer having a carrier concentration of $1.5 \times 10^{18}$ cm$^{-3}$ to $2.9 \times 10^{18}$ cm$^{-3}$ and a maximum value for etch pit density of 1,200 cm$^{-2}$ or less from 70% or more (preferably 90% or more) of the straight body section, or to obtain a GaAs ingot that includes a straight body section having a diameter of more than 140 mm and yields a wafer having a carrier concentration of $1.5 \times 10^{18}$ cm$^{-3}$ to $2.9 \times 10^{18}$ cm$^{-3}$ and a maximum value for etch pit density of 1,500 cm$^{-2}$ or less from 70% or more of the straight body section.

In other words, in a case in which the straight body section of the GaAs ingot has a diameter of 140 mm or less, 70% or more (preferably 90% or more) of wafers among the total number of wafers that can be cut out from the straight body section satisfy conditions of the carrier concentration being $1.5 \times 10^{18}$ cm$^{-3}$ to $2.9 \times 10^{18}$ cm$^{-3}$ and the maximum value for etch pit density being 1,200 cm$^{-2}$ or less. The maximum value for etch pit density is more preferably 1,000 cm$^{-2}$ or less. The lower limit for the maximum value for etch pit density is not specifically limited and may be 0.

It is more preferable that 92% or more of wafers satisfy the conditions set forth above. It may be the case that all wafers (100% of wafers) satisfy the conditions set forth above.

In a case in which the straight body section of the GaAs ingot has a diameter of more than 140 mm, 70% or more of wafers among the total number of wafers that can be cut out from the straight body section satisfy conditions of the carrier concentration being $1.5 \times 10^{18}$ cm$^{-3}$ to $2.9 \times 10^{18}$ cm$^{-3}$ and the maximum value for etch pit density being 1,500 cm$^{-2}$ or less. The lower limit for the maximum value for etch pit density is not specifically limited and may be 0.

It is more preferable that 75% or more of wafers satisfy the conditions set forth above. It may be the case that all wafers (100% of wafers) satisfy the conditions set forth above.

(Measurement method of carrier concentration)

The carrier concentration is taken to be a value that is measured by dividing out a central portion of a wafer taken from a GaAs ingot with a size of 10 mm × 10 mm, attaching indium electrodes at four corners, performing heating to 330°C to 360°C, and subsequently performing Hall measurement according to the Van der Pauw method.

(Measurement method of etch pit density (EPD))

Measurement of the etch pit density (EPD) is performed by using a sulfuric acid-based mirror surface etchant ($H_2SO_4$:$H_2O_2$:$H_2O$ = 3:1:1 (volume ratio)) to pretreat the surface of a wafer taken from a GaAs ingot, subsequently immersing the wafer in a KOH melt having a liquid temperature of 320°C for 35 minutes to cause formation of etch pits, and measuring the number of etch pits. Etch pits having a major axis (length of a diagonal line passing through the center) of 20

μm or more that are formed with a shape like a hexagonal shape that is characteristic of a sphalerite-type crystal are taken as measurement subjects.

In measurement of the etch pit density (EPD), 69 areas or 37 areas of 3 mm in diameter are set on the wafer, each area is observed using a microscope, and etch pits that have been formed are counted.

The 69 or 37 areas are distributed evenly over the entire surface of the wafer.

In the case of a 6 inch wafer, 69 areas are set at positions that are evenly dispersed at intervals of 15 mm, whereas in the case of a 3 inch wafer, 37 areas are set at positions that are evenly dispersed at intervals of 10 mm.

When 69 areas are set at positions that are evenly dispersed, the areas are at intervals of 5 mm in the case of a 2 inch wafer, intervals of 10 mm in the case of a 4 inch wafer, and intervals of 20 mm in the case of an 8 inch wafer.

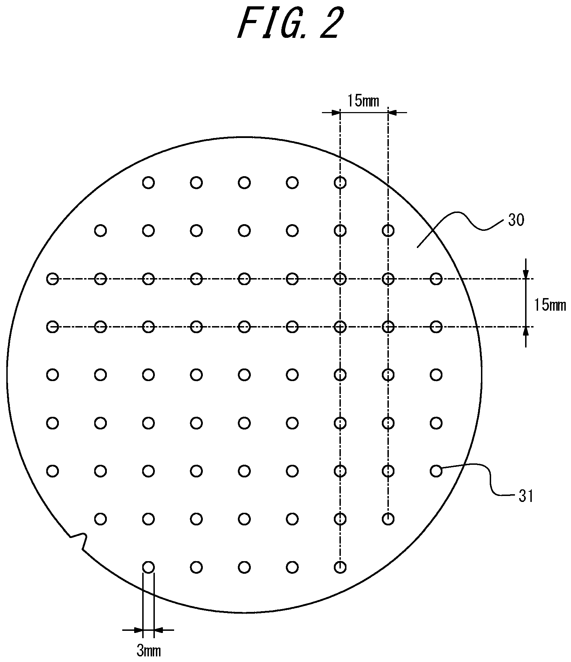

FIG. 2 illustrates a schematic view in which 69 areas are set in a 6 inch wafer.

Observation of each area is performed using a $\times$10 objective lens giving a viewing field diameter of 1.73 mm. For each of the areas, a viewing field in which pits are most abundantly observed in that area is found, etch pits in that viewing field are counted, and the counted number of etch pits is converted to a number per unit area ($cm^{-2}$). A maximum value among the converted values for the counted numbers of etch pits in the various areas is taken to be a maximum value for etch pit density (EPD). Moreover, an average value of the converted values for the counted numbers of etch pits in the various areas is taken to be an average value for etch pit density (EPD).

The GaAs wafer according to the present disclosure has a strictly controlled carrier concentration and a low dislocation density, and is suitable as a substrate of a VCSEL (vertical-cavity surface-emitting laser) and other such surface-emitting lasers.

The preceding description illustrates examples of representative embodiments of the present disclosure, but the present disclosure is not limited to these embodiments.

EXAMPLES

The following provides an even more detailed description of the present disclosure through examples. However, the present disclosure is not in any way limited by the following examples.

(GaAs feedstock)

<GaAs feedstock 1>

GaAs feedstock 1 is polycrystalline GaAs produced through synthesis of 6N (purity of 99.9999% or higher) Ga and 6N As.

<GaAs feedstock 2>

GaAs feedstock 2 is Si-doped polycrystalline GaAs synthesized by a vertical boat method using 350 wt ppm of high-purity Si relative to 6N (purity of 99.9999% or higher) Ga and 6N As and not using $B_2O_3$ as an encapsulant. The Si concentration calculated from a measurement value in Hall measurement is 80 wt ppm relative to GaAs. Since $B_2O_3$ is not used, boron is not added to the Si-doped polycrystalline GaAs.

<GaAs feedstock 3>

GaAs feedstock 3 is a recycled product obtained through crushing of a section other than a straight body section in another single crystal ingot. The Si concentration calculated from a measurement value in Hall measurement is 33 wt ppm relative to GaAs. Boron is contained in the feedstock.

<GaAs feedstock 4>

GaAs feedstock 4 is Si-doped polycrystalline GaAs synthesized by a vertical boat method using 450 wt ppm of high-purity Si relative to 6N (purity of 99.9999% or higher) Ga and 6N As and not using $B_2O_3$ as an encapsulant. The Si concentration calculated from a measurement value in Hall measurement is 175 wt ppm relative to GaAs. Since $B_2O_3$ is not used, boron is not added to the Si-doped polycrystalline GaAs.

(Encapsulant)

<Encapsulant 1>

Encapsulant 1 is $B_2O_3$ containing $SiO_2$ in a Si-equivalent amount of 7 mol%.

<Encapsulant 2>

Encapsulant 2 is $B_2O_3$ containing $SiO_2$ in a Si-equivalent amount of 5.3 mol%.

(Crystal No. 1)

A GaAs ingot was produced using a production apparatus having the configuration illustrated in FIG. 3. The stirring blade has four plate-like members that have a quadrangular shape and are formed of a material such as carbon or BN that does not affect crystal characteristics attached to a rod, and the area formed by the rotation trajectory of the stirring blade during rotation is 50% or more of the area of an interface formed by a GaAs melt and $B_2O_3$ when in a stationary state.

<Loading of feedstocks into crucible>

A crucible made of PBN that had an internal diameter of 112 mm and a seed section internal diameter of 6 mm to 6.5 mm was prepared as a crucible. As illustrated in FIG. 4, the crucible was loaded with 11,900 g of the GaAs feedstock 1 and a GaAs seed crystal that had been cut out such that a (100) plane was a crystal growth plane. The diameter of the GaAs seed crystal was of a size adjusted through a combination of machine grinding and etching to be 0.5 mm smaller than the seed section internal diameter of the crucible. Partway through loading of the GaAs feedstock 1, high-purity Si shot as a dopant (Si feedstock) was loaded in an amount of 300 wt ppm relative to GaAs. With the exception of Si, impurity elements were not intentionally added. Note that the granular dopant (Si feedstock) 10 was loaded in a state in which it was placed in a GaAs container having circular tube-shaped polycrystalline GaAs 9B sandwiched from above and below by disk-shaped polycrystalline GaAs 9C such that the dopant in the container did not migrate outside of the GaAs container until the temperature at which the GaAs container melts was reached.

<Crystal growth>

After loading of these feedstocks, 550 g of the encapsulant 1 was loaded. The crucible after loading was set in a crucible receiving container (susceptor). The inside of the production apparatus illustrated in FIG. 3 was subjected to repeated vacuum evacuation and Ar gas purging to provide an inert gas atmosphere therein, and then a single crystal was grown by the VGF method.

In the crystal growth process, the feedstocks in the crucible were first heated to at least the melting point of GaAs (1238°C) to obtain a melt while applying a temperature gradient through a PID controlled heater such that there was a lower temperature at the seed crystal side in order that the GaAs seed crystal did not melt. Thereafter, the temperature in proximity to the seed crystal was raised such that the top of the seed crystal melted, and then the temperature of the entire inside of the furnace was lowered at a rate of 0.5°C/h or less through heater control while applying a temperature gradient so as to grow an n-type GaAs ingot having Si as a dopant.

At the point at which the crystal growth of a cone section had occurred and the ingot had grown to a location reaching a crystal straight body section, the stirring blade was positioned in the encapsulant such that the distance to a lower end of the stirring blade from an interface of the encapsulant (boron oxide) and the feedstock melt was 1 mm or less and such that the lower end was not in contact with the interface. The rotation speed of the stirring blade was kept as 0 rpm in growth up to a midpoint, was set as 0.5 rpm from the midpoint to a tail, and stirring was continued until growth of the tail was complete.

The obtained GaAs ingot has n-type conductivity.

<Evaluation>

The straight body section of the grown GaAs ingot was sliced into a wafer shape using a wire saw. The wafer size is equivalent to 4 inches. The length of the straight body section was 297 wafers in terms of the total number of wafers obtained from the straight body section, and the position from the straight body seed was calculated for each wafer. Measurement of carrier concentration was performed by the previously described method with respect to wafers that were cut out at positions from the straight body seed indicated in Table 1. Moreover, measurement of average and maximum values for EPD was performed by the previously described method with respect to wafers that were cut out at positions from the straight body seed indicated in Table 1.

Furthermore, with regards to carrier concentration and EPD from the seed side to the tail side that are measured wafer positions indicated in Table 1 ($1^{st}$ wafer to $287^{th}$ wafer), for positions between measured values, a midpoint value taken by joining the measured values by a straight line was calculated for that position in order to calculate the proportion of wafers in the measurement range from the seed side to the tail side that had a carrier concentration of $1.5 \times 10^{18}$ cm$^{-3}$ to $2.9 \times 10^{18}$ cm$^{-3}$ and a maximum value for etch pit density of 1,200 cm$^{-2}$ or less (i.e., the proportion of wafers satisfying specific conditions) relative to the total number of wafers (297 wafers) that were cut out from the GaAs ingot. This proportion is shown in Table 1. In calculation of the proportion of wafers satisfying the specific conditions, wafers at positions further outward than a wafer furthest to the tail side among the measurement subject wafers (i.e., wafers at a side close to where the position from the straight body seed is 100%) were considered to not satisfy the specific conditions.

(Crystals Nos. 2 and 3)

GaAs ingots of Crystals Nos. 2 and 3 were produced and evaluated in the same way as Crystal No. 1 with the exception that the conditions were changed as indicated in Table 1. The obtained GaAs ingots have n-type conductivity.

(Crystal No. 4)

A GaAs ingot of Crystal No. 4 was produced and evaluated in the same way as Crystal No. 1 with the exception that after the GaAs seed crystal, the GaAs feedstock 1, and the high-purity Si shot had been loaded, a quartz plate (disk shape of 51 mm in diameter and 5 mm in thickness) was arranged above these materials, and then the encapsulant 1 was loaded. The obtained GaAs ingot has n-type conductivity.

[Table 1]

Table 1

| Crystal No. | Feedstocks | | | Total charged amount of Si wt ppm | Position from straight body seed | Position | Carrier concentration cm$^{-3}$ | EPD | | Proportion of wafers satisfying specific conditions % |
| --- | --- | --- | --- | --- | --- | --- | --- | --- | --- | --- |
| | GaAs feedstock | Charged amount of Si wt ppm | Encapsulant | | | | | Average value cm$^{-2}$ | Maximum value cm$^{-3}$ | |
| 1 | GaAs feed-stock 1 | 300 | Encapsulant 1 | 300 | 0.3% | Seed side | $1.32 \times 10^{18}$ | 14 | 900 | 60.9% |
| | | | | | 34.0% | | $1.79 \times 10^{18}$ | 9 | 500 | |
| | | | | | 47.5% | Central portion | $2.13 \times 10^{18}$ | - | - | |
| | | | | | 72.7% | | - | 12 | 800 | |
| | | | | | 79.5% | | $1.99 \times 10^{18}$ | 39 | 2300 | |
| | | | | | 87.9% | | - | 75 | 1900 | |
| | | | | | 96.6% | Tail side | $1.64 \times 10^{18}$ | 100 | 1500 | |
| 2 | GaAs feedstock 2 | 280 | Encapsulant 1 | 360 | 0.3% | Seed side | $1.60 \times 10^{18}$ | 19 | 200 | 96.6% |
| | | | | | 34.0% | | $2.18 \times 10^{18}$ | 25 | 300 | |
| | | | | | 47.5% | Central portion | $2.49 \times 10^{18}$ | - | - | |
| | | | | | 79.5% | | $2.63 \times 10^{18}$ | 29 | 600 | |
| | | | | | 96.6% | Tail side | $2.19 \times 10^{18}$ | 84 | 900 | |
| 3 | GaAs feedstock 2 | 250 | Encapsulant 1 | 330 | 0.3% | Seed side | $1.50 \times 10^{18}$ | - | - | 96.6% |
| | | | | | 34.0% | | $2.01 \times 10^{18}$ | - | - | |
| | | | | | 47.5% | Central portion | $2.34 \times 10^{18}$ | - | - | |
| | | | | | 72.7% | | - | 10 | 700 | |
| | | | | | 79.5% | | $2.65 \times 10^{18}$ | 43 | 900 | |
| | | | | | 87.9% | | - | 94 | 900 | |
| | | | | | 96.6% | Tail side | $1.85 \times 10^{18}$ | 123 | 1200 | |

EP 4 592 431 A1

| Crystal No. | Feedstocks | | | Total charged amount of Si wt ppm | Position from straight body seed | Position | Carrier concentration cm$^{-3}$ | EPD | | Proportion of wafers satisfying specific conditions % |
|---|---|---|---|---|---|---|---|---|---|---|
| | GaAs feedstock | Charged amount of Si wt ppm | Encapsulant | | | | | Average value cm$^{-2}$ | Maximum value cm$^{-3}$ | |
| 4 | GaAs feed-stock 1 | 300 | Encapsulant 1 Quartz plate | 300 | 0.3% | Seed side | $1.56 \times 10^{18}$ | 9 | 200 | 67.6% |
| | | | | | 34.0% | Central portion | $2.08 \times 10^{18}$ | 7 | 300 | |
| | | | | | 47.5% | | $2.40 \times 10^{18}$ | - | - | |
| | | | | | 79.5% | | $\underline{3.22 \times 10^{18}}$ | 6 | 400 | |
| | | | | | 96.6% | Tail side | $2.41 \times 10^{18}$ | 28 | 800 | |

"-" indicates not measured

EP 4 592 431 A1

Table 1 indicates GaAs ingots for which the diameter of the straight body section was 140 mm or less. In the case of Crystals Nos. 2 and 3, for wafers in the measurement range from the seed side to the tail side in Table 1, 96.6% of the total number of wafers (297 wafers) satisfied conditions of the carrier concentration being $1.5 \times 10^{18}$ cm$^{-3}$ to $2.9 \times 10^{18}$ cm$^{-3}$ and the maximum value for etch pit density being 1,200 cm$^{-2}$ or less.

In the case of Crystal No. 1, which is an example in which a GaAs ingot was grown using a high-purity polycrystalline GaAs feedstock that was not doped with Si, the proportion of wafers satisfying the aforementioned conditions was only 60.9%.

Moreover, Crystal No. 4 is an example in which a GaAs ingot was produced using a quartz plate and corresponds to PTL 1. In this example, the quartz plate reduced the effect of suppressing an increase of Si concentration through stirring, and thus it was not possible to suppress an increase of carrier concentration beyond the central portion, and the proportion of wafers satisfying the aforementioned conditions was only 67.6%.

In the case of Crystals Nos. 1 and 4, the proportion of wafers satisfying the conditions is less than 70% even when the specific conditions are presumed to be satisfied by wafers that, relative to a wafer furthest to the tail side among the measurement subject wafers, are at positions at a side closer to where the position from the straight body seed is 100%.

(Crystal No. 5)

<Loading of feedstocks into crucible>

A crucible made of PBN that had an internal diameter of 159.9 mm and a seed section internal diameter of 6.0 mm to 6.5 mm was prepared as a crucible. The crucible was loaded with 20,000 g of the GaAs feedstock 1 and a GaAs seed crystal that had been cut out such that a (100) plane was a crystal growth plane. The diameter of the GaAs seed crystal was of a size adjusted through a combination of machine grinding and etching to be approximately 0.5 mm smaller than the seed section internal diameter of the crucible. Partway through loading of the polycrystalline GaAs, high-purity Si shot as a dopant (Si feedstock) was loaded in an amount of 210 wt ppm relative to GaAs. With the exception of Si, impurity elements were not intentionally added.

<Crystal growth>

After loading of these feedstocks, 965 + 10 g of the encapsulant 2 was loaded. The crucible after loading was set in a crucible receiving container (susceptor). The inside of the production apparatus illustrated in FIG. 3 was subjected to repeated vacuum evacuation and Ar gas purging to provide an inert gas atmosphere therein, and then a single crystal was grown by the VGF method.

In the crystal growth process, the feedstocks in the crucible were first heated to at least the melting point of GaAs (1238°C) to obtain a melt while applying a temperature gradient through a PID controlled heater such that there was a lower temperature at the seed crystal side in order that the GaAs seed crystal did not melt. Thereafter, the temperature in proximity to the seed crystal was raised such that the top of the seed crystal melted, and then the temperature of the entire inside of the furnace was lowered at a rate of 0.5°C/h or less through heater control while applying a temperature gradient so as to grow an n-type GaAs ingot having Si as a dopant.

At the point at which the crystal growth of a cone section had occurred and the ingot had grown to a location reaching a crystal straight body section, the stirring blade was positioned in the encapsulant such that the distance to a lower end of the stirring blade from an interface of the boron oxide serving as the encapsulant and the feedstock melt was 1 mm or less and such that the lower end was not in contact with the interface. The rotation speed of the stirring blade 20 was kept as 0 rpm in growth up to a midpoint, was set as 0.5 rpm from the midpoint to a tail, and stirring was continued until growth of the tail was complete.

The obtained GaAs ingot has n-type conductivity.

<Evaluation>

The straight body section of the grown GaAs ingot was sliced into a wafer shape using a wire saw. The wafer size is equivalent to 6 inches. The length of the straight body section was 161 wafers in terms of the total number of wafers obtained from the straight body section, and the position from the straight body seed was calculated for each wafer. The final cutting surface is at a position 20 mm from the opposite end of the ingot to the seed crystal side (i.e., a position 20 mm in a direction toward the seed side from the opposite end). Measurement of carrier concentration was performed by the previously described method with respect to wafers that were cut out at positions from the straight body seed indicated in Table 2. Moreover, measurement of average and maximum values for EPD was performed by the previously described method with respect to wafers that were cut out at positions from the straight body seed indicated in Table 2.

Furthermore, with regards to carrier concentration and EPD from the seed side to the tail side that are measured wafer positions indicated in Table 2 ($2^{nd}$ wafer to $148^{th}$ wafer), for positions between measured values, a midpoint value taken by joining the measured values by a straight line was calculated for that position in order to calculate the proportion of wafers in the measurement range from the seed side to the tail side that had a carrier concentration of $1.5 \times 10^{18}$ cm$^{-3}$ to $2.9 \times 10^{18}$ cm$^{-3}$ and a maximum value for etch pit density of 1,500 cm$^{-2}$ or less (i.e., the proportion of wafers satisfying specific conditions) relative to the total number of wafers (161 wafers) that were cut out from the GaAs ingot. This proportion is shown in Table 2. In calculation of the proportion of wafers satisfying the specific conditions, wafers at positions further outward than the measurement subject wafers were considered to not satisfy the specific conditions.

(Crystal No. 6)

A GaAs ingot of Crystal No. 6 was produced and evaluated in the same way as Crystal No. 5 with the exception that the conditions were changed as indicated in Table 2. The obtained GaAs ingot has n-type conductivity.

(Crystal No. 7)

A GaAs ingot of Crystal No. 7 was produced and evaluated in the same way as Crystal No. 6 with the exception that the GaAs feedstock 4 (Si concentration: 175 wt ppm) was used as indicated in Table 2 and that the rotation speed of the stirring blade was kept as 0 rpm in growth up to the midpoint and was then set as 2.5 rpm from the midpoint to the tail. The obtained GaAs ingot has n-type conductivity.

[Table 2]

EP 4 592 431 A1

Table 2

| Crystal No. | Feedstocks | | | Total charged amount of Si wt ppm | Position from straight body seed | Position | Carrier concentration cm$^{-3}$ | EPD | | Proportion of wafers satisfying specific conditions % |
| --- | --- | --- | --- | --- | --- | --- | --- | --- | --- | --- |
| | GaAs feedstock | Charged amount of Si wt ppm | Encapsulant | | | | | Average value cm$^{-3}$ | Maximum value cm$^{-2}$ | |
| 5 | GaAs feedstock 1 | 210 | Encapsulant 2 | 210 | 1% | Seed side | $8.94 \times 10^{17}$ | - | 0 | 37.7% |
| | | | | | 49% | Central portion | $1.46 \times 10^{18}$ | - | 0 | |
| | | | | | 69% | | - | - | 0 | |
| | | | | | 80% | | $1.96 \times 10^{18}$ | - | 0 | |
| | | | | | 92% | Tail side | $2.00 \times 10^{18}$ | - | - | |
| 6 | GaAs feedstock 3 | 250 | Encapsulant 1 | 283 | 1% | Seed side | $1.36 \times 10^{18}$ | - | 0 | 79.1% |
| | | | | | 14% | | $1.50 \times 10^{18}$ | - | - | |
| | | | | | 49% | Central portion | $2.09 \times 10^{18}$ | - | 0 | |
| | | | | | 63% | | $2.38 \times 10^{18}$ | - | 0 | |
| | | | | | 69% | | $2.54 \times 10^{18}$ | - | 700 | |
| | | | | | 74% | | $2.66 \times 10^{18}$ | - | 953 | |
| | | | | | 80% | | $2.78 \times 10^{18}$ | - | 1500 | |
| | | | | | 92% | Tail side | $2.88 \times 10^{18}$ | - | 2800 | |
| 7 | GaAs feedstock 4 | 250 | Encapsulant 1 | 425 | 1% | Seed side | $1.64 \times 10^{18}$ | 0 | 0 | 77.1% |
| | | | | | 39% | | $2.30 \times 10^{18}$ | 0 | 0 | |
| | | | | | 49% | Central portion | $2.43 \times 10^{18}$ | 13 | 900 | |
| | | | | | 58% | | $2.56 \times 10^{18}$ | 19 | 800 | |
| | | | | | 69% | | $2.76 \times 10^{18}$ | 32 | 800 | |
| | | | | | 77% | | $2.83 \times 10^{18}$ | 90 | 1500 | |

"-" indicates not measured

16

Table 2 indicates GaAs ingots for which the diameter of the straight body section was more than 140 mm. In the case of Crystal No. 6, for wafers in the measurement range from the seed side to the tail side that were obtained from the straight body section, 79.1% of the total number of wafers (161 wafers) satisfied conditions of the carrier concentration being $1.5 \times 10^{18}$ cm$^{-3}$ to $2.9 \times 10^{18}$ cm$^{-3}$ and the maximum value for etch pit density being 1,500 cm$^{-2}$ or less.

In the case of Crystal No. 7, for wafers in the measurement range from the seed side to the tail side that were obtained from the straight body section, 77.1% of the total number of wafers (161 wafers) satisfied conditions of the carrier concentration being $1.5 \times 10^{18}$ cm$^{-3}$ to $2.9 \times 10^{18}$ cm$^{-3}$ and the maximum value for etch pit density being 1,500 cm$^{-2}$ or less.

In contrast, in the case of Crystal No. 5, which is an example in which a GaAs ingot was grown using a high-purity polycrystalline GaAs feedstock that was not doped with Si, the proportion of wafers satisfying the aforementioned conditions was only 37.7%.

In the case of Crystal No. 5, the proportion of wafers satisfying the conditions is less than 70% even when the specific conditions are presumed to be satisfied by wafers at positions further outward than the measurement subject wafers.

INDUSTRIAL APPLICABILITY

According to the present disclosure, it is possible to provide a GaAs ingot that efficiently yields a GaAs wafer having a strictly controlled carrier concentration and a low dislocation density and a method of producing this GaAs ingot, and thus the present disclosure has high industrial usefulness.

REFERENCE SIGNS LIST

1       heater
2       crucible receiving container (susceptor)
3       crucible
4       boron oxide
5       compound semiconductor feedstock (feedstock melt)
6       seed crystal
7       airtight container
8       inert gas
9       polycrystalline GaAs feedstock
10      Si feedstock
14      crucible raising/lowering and rotating mechanism
15      position where cone section changes to straight body section
16      position (midpoint) halfway between position 15 and position

17      position where straight body section ends
18      straight body section of GaAs ingot
19      cone section of GaAs ingot
20      stirring blade
21      upper rod
30      6 inch wafer
31      area

**Claims**

1.  A method of producing a GaAs ingot comprising performing crystal growth by a vertical boat method with a seed crystal, a Si feedstock serving as a dopant, a GaAs feedstock, and boron oxide serving as an encapsulant accommodated in a crucible, wherein

    the GaAs feedstock is Si-doped GaAs having a Si concentration of 20 wt ppm to 200 wt ppm relative to GaAs, a charged amount of the Si feedstock is 200 wt ppm to 300 wt ppm relative to GaAs, the boron oxide contains SiO$_2$ in a Si-equivalent amount of more than 5 mol%, and the crystal growth is performed under stirring of liquid boron oxide after melting the Si feedstock, the GaAs feedstock, and the boron oxide through heating.

2. The method of producing a GaAs ingot according to claim 1, wherein the method is:

a method of producing a GaAs ingot including a straight body section having a diameter of 140 mm or less, wherein a total charged amount of Si determined by totaling Si in the GaAs feedstock and the Si feedstock is more than 300 wt ppm relative to GaAs; or
a method of producing a GaAs ingot including a straight body section having a diameter of more than 140 mm, wherein the charged amount of the Si feedstock is 200 wt ppm to 250 wt ppm relative to GaAs, and a total charged amount of Si determined by totaling Si in the GaAs feedstock and the Si feedstock is more than 250 wt ppm relative to GaAs.

3. A GaAs ingot that:

comprises a straight body section having a diameter of 140 mm or less and yields a wafer having a carrier concentration of $1.5 \times 10^{18}$ cm$^{-3}$ to $2.9 \times 10^{18}$ cm$^{-3}$ and a maximum value for etch pit density of 1,200 cm$^{-2}$ or less from 70% or more of the straight body section; or
comprises a straight body section having a diameter of more than 140 mm and yields a wafer having a carrier concentration of $1.5 \times 10^{18}$ cm$^{-3}$ to $2.9 \times 10^{18}$ cm$^{-3}$ and a maximum value for etch pit density of 1,500 cm$^{-2}$ or less from 70% or more of the straight body section.

# FIG. 1

# *FIG. 2*

# FIG. 3

# FIG. 4

# INTERNATIONAL SEARCH REPORT

| | International application No. |
|---|---|
| | **PCT/JP2023/033402** |

**A. CLASSIFICATION OF SUBJECT MATTER**

**C30B 29/42**(2006.01)i; **C30B 11/00**(2006.01)i; **C30B 27/00**(2006.01)i
FI: C30B29/42; C30B11/00 Z; C30B27/00

According to International Patent Classification (IPC) or to both national classification and IPC

**B. FIELDS SEARCHED**

Minimum documentation searched (classification system followed by classification symbols)

C30B29/42; C30B11/00; C30B27/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2012-246156 A (DOWA ELECTRONICS MATERIALS CO., LTD.) 13 December 2012 (2012-12-13) paragraphs [0035]-[0056] | 3 |
| A | | 1, 2 |
| X | JP 2012-006829 A (DOWA ELECTRONICS MATERIALS CO., LTD.) 12 January 2012 (2012-01-12) paragraphs [0033]-[0039], [0058]-[0060], [0072]-[0077] | 3 |
| A | | 1, 2 |
| A | WO 2019/008663 A1 (SUMITOMO ELECTRIC INDUSTRIES, LTD.) 10 January 2019 (2019-01-10) entire text | 1-3 |
| A | JP 2010-526755 A (AXT INC.) 05 August 2010 (2010-08-05) entire text | 1-3 |
| A | US 2020/0190696 A1 (AXT, Inc.) 18 June 2020 (2020-06-18) entire text | 1-3 |

☐ Further documents are listed in the continuation of Box C.  ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **21 November 2023** | **05 December 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

### INTERNATIONAL SEARCH REPORT
Information on patent family members

International application No.

**PCT/JP2023/033402**

| Patent document cited in search report | | | Publication date (day/month/year) | Patent family member(s) | | | Publication date (day/month/year) |
|---|---|---|---|---|---|---|---|
| JP | 2012-246156 | A | 13 December 2012 | US | 2014/0205527 | A1 | |
| | | | | paragraphs [0037]-[0061] | | | |
| | | | | WO | 2012/160781 | A1 | |
| | | | | DE | 112012002217 | B | |
| | | | | TW | 201250073 | A | |
| | | | | SG | 195154 | A | |
| | | | | CN | 103703172 | A | |
| | | | | KR | 10-2014-0044831 | A | |
| | | | | TW | 201704569 | A | |
| JP | 2012-006829 | A | 12 January 2012 | US | 2009/0098377 | A1 | |
| | | | | paragraphs [0043]-[0051], [0075]-[0079], [0094]-[0105] | | | |
| | | | | US | 2011/0059294 | A1 | |
| | | | | WO | 2006/106644 | A1 | |
| | | | | DE | 112006000771 | B | |
| | | | | TW | 200722562 | A | |
| WO | 2019/008663 | A1 | 10 January 2019 | US | 2019/0264348 | A1 | |
| | | | | entire text | | | |
| | | | | JP | 6394838 | B1 | |
| | | | | EP | 3508621 | A1 | |
| | | | | EP | 4063541 | A1 | |
| | | | | TW | 201907060 | A | |
| | | | | CN | 110325672 | A | |
| | | | | CN | 113215662 | A | |
| | | | | CN | 113235162 | A | |
| | | | | TW | 202136599 | A | |
| JP | 2010-526755 | A | 05 August 2010 | US | 2008/0280427 | A1 | |
| | | | | entire text | | | |
| | | | | US | 2010/0001288 | A1 | |
| | | | | US | 2011/0089538 | A1 | |
| | | | | US | 2011/0293890 | A1 | |
| | | | | WO | 2008/140763 | A1 | |
| | | | | WO | 2013/023194 | A1 | |
| | | | | CN | 101307501 | A | |
| | | | | CN | 101688323 | A | |
| | | | | JP | 2015-006988 | A | |
| US | 2020/0190696 | A1 | 18 June 2020 | CN | 111321456 | A | |

Form PCT/ISA/210 (patent family annex) (January 2015)

## REFERENCES CITED IN THE DESCRIPTION

**Patent documents cited in the description**

- JP 2012246156 A